Europäisches Patentamt

European Patent Office

Office européen des brevets

(11) Veröffentlichungsnummer: **0 057 892**
**A2**

(12) **EUROPÄISCHE PATENTANMELDUNG**

(21) Anmeldenummer: 82100691.3

(22) Anmeldetag 01.02.82

(51) Int. Cl.³: **H 05 K 7/00**
**H 05 K 11/02, G 12 B 9/02**
**G 05 G 1/02**

(30) Priorität 10.02.81 DE 3104668

(43) Veröffentlichungstag der Anmeldung:
18.08.82 Patentblatt 82/33

(84) Benannte Vertragsstaaten:
DE FR GB IT SE

(71) Anmelder: SIEMENS AKTIENGESELLSCHAFT Berlin
und München
Postfach 22 02 61
D-8000 München 22(DE)

(72) Erfinder: Müller, Rüdiger, Dr.-Ing.
Putzbrunnerstrasse 131
D-8000 München 83(DE)

(54) Multifunktionsbedienteil.

(57) Die Erfindung betrifft ein Multifunktionsbedienteil mit einer Zifferneingabe (1), Funktionsgruppen-Umschaltung und Bedienung (2), die über eine Verarbeitungselektronik (3) mit einer Anzeigeeinheit (4) verbunden sind. Über eine serielle Schnittstelle (5) ist das Bedienteil mit einer Elektronikeinheit (6) verbunden, welche die einzelnen zu bedienenden Geräte (7, 8, 9) enthält. Das Multifunktionsbedienteil ist insbesondere zur Anwendung in Kraftfahrzeugen vorgesehen.

FIG1

EP 0 057 892 A2

Croydon Printing Company Ltd.

0 0 5 7 8 9 2

SIEMENS  AKTIENGESELLSCHAFT    Unser Zeichen
Berlin und München                VPA    81 P 1 0 1 6 E

5   <u>Multifunktionsbedienteil</u>

Die Erfindung betrifft ein Multifunktionsbedienteil,
insbesondere für Kraftfahrzeuge.

Wegen der fortschreitenden Digitalisierung elektronischer Geräte werden die Bedienteile einzelner Geräte
immer ähnlicher. Trotzdem werden im Kraftfahrzeug beispielsweise für den Bordcomputer, das Frequenzsynthese-
Autoradio und das Autotelefon bis jetzt getrennte Zifferneingabemöglichkeiten verwendet. Weiterhin sind die
genannten einzelnen Geräte separiert und an verschiedenen Stellen im Kraftfahrzeug untergebracht.

Aufgabe der Erfindung ist es daher ein Bedienteil anzugeben, welches für alle im Kraftfahrzeug vorhandenen
Geräte benutzbar ist.

Diese Aufgabe wird erfindungsgemäß durch ein Multifunktionsbedienteil gelöst, welches die folgenden Funktionsgruppen aufweist:

a) Eine Zifferneingabe,
b) eine Funktionsgruppenumschaltung,
c) Bedienelemente,
d) eine Anzeigeeinheit,
e) eine serielle Schnittstelle für eine Elektronikeinheit.

Durch das erfindungsgemäße Multifunktonsbedienteil erzielt man die Vorteile, daß neben einer einfacheren Be-

Sac 1 Rau  09.02.1981

dienung der einzelnen Geräte zusätzlich Platz- und Gewichtseinsparungen erzielt werden.

Gemäß einer Weiterbildung der Erfindung ist die serielle Schnittstelle für einen elektrischen Datenbus ausgebildet.

Eine weitere vorteilhafte Ausgestaltung sieht vor, daß die serielle Schnittstelle für eine Infrarot-Datenübertragung ausgebildet ist und das MFBT als tragbares Gerät ausgebildet wird. Damit wird der Vorteil erzielt, daß zum Beispiel auch auf den Rücksitzen eines Kraftfahrzeuges sitzende Personen das Multifunktionsbedienteil bedienen können.

Weitere Ausgestaltungen der Erfindung sehen vor, daß die Zifferneingabe entweder mittels Drucktasten oder mittels Drehschaltern oder mittels Sensortasten oder mittels einer Spracherkennung erfolgt.

Die Anzeigeeinheit ist vorteilhaft als LCD-Display ausgebildet.

Bei einer bevorzugten Ausführungsform der Erfindung sind Zifferneingabe, Funktionsgruppenumschaltung, Bedienelemente und die Anzeigeeinheit auf einem LCD-Matrixdisplay mit überlagerten Sensortasten angeordnet. Diese Ausführungsform hat den Vorteil, daß eine Tastatur mit wahlfreier Beschriftung (Text, Ziffern, Piktogramme) angewandt werden kann.

Weitere Vorteile der Erfindung werden anhand der folgenden Ausführungsbeispiele erläutert. In der dazugehörenden Zeichnung zeigen:

Fig. 1 ein Blockschaltbild und

Fig. 2 ein Ausführungsbeispiel des Multifunktionsbedienteils.

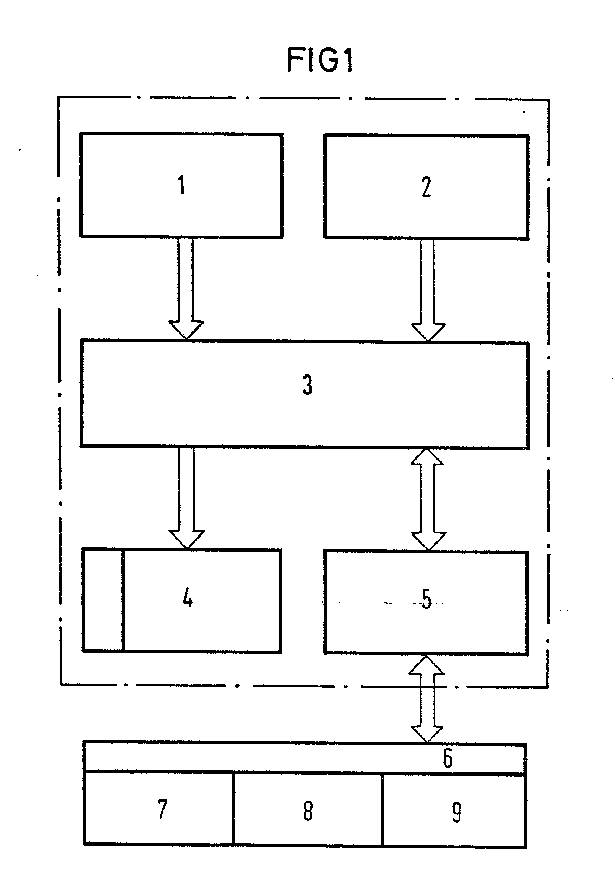

In der Fig. 1 ist ein Blockschaltbild des erfindungsgemäßen Multifunktionsbedienteils dargestellt. Das Bedienteil weist dabei die in der Figur strich-punktiert umrahmten Elemente, nämlich eine Zifferneingabe 1 und eine Funktionsgruppenumschaltung und Bedienung 2 auf, welche über eine Verarbeitungselektronik 3 mit einer Anzeigeeinheit 4 gekoppelt sind. Weiterhin weist das Bedienteil eine serielle Schnittstelle 5 für eine Elektronikeinheit 6 auf.

Die Zifferneingabe 1, welche z. B. mit Drucktasten, Drehschaltern, Sensortasten oder mittels einer Spracherkennung arbeitet, weist gegebenenfalls Korrekturmöglichkeiten und eine Enterfunkton auf. Die Funktionsgruppenumschaltung und Bedienung 2, mit welcher die einzelnen Geräte wie beispielsweise Bordcomputer, Autoradio, Autotelefon angewählt und bedient werden, kann die gleichen Eingabeelemente, wie die Zifferneingabe, aufweisen.

Die Anzeigeeinheit 4 zeigt beispielsweise den Betriebsmode bzw. die mit der Zifferneingabe 1 angegebenen Ziffern an und dient weiterhin der Information und Benutzerführung. Die Anzeigeeinheit 4 kann beispielsweise als LCD-Display ausgebildet sein, kann aber auch aus einer Sprachausgabe bestehen, insbesondere wenn die Zifferneingabe und die Funktionsgabe und die Funktionsgruppenumschaltung und Bedienung mittels Spracherkennung arbeitet.

Die serielle Schnittstelle 5 zur Elektronikeinheit 6 ist beispielsweise für einen elektrischen Datenbus eingerichtet, kann aber auch mittels einer Infrarot-Datenübertragung arbeiten, wodurch die Bedienung von jedem Platz des Kraftfahrzeuges aus ermöglicht wird.

In der Elektronikeinheit 6 können beispielsweise das Autoradio 7, das Autotelefon 8 und der Bordcomputer 9 enthalten sein. Diese Elektronikeinheit 6 kann an beliebiger Stelle im Kraftfahrzeug untergebracht sein, beispielsweise im Kofferraum oder in der Mittelkonsole.

Mit der Anzeigeeinheit 4 kann neben dem Betriebsmode (das heißt Art der Funktion), der Information (zum Beispiel Bordcomputerfunktion, Telefonnummer) eine Benutzerführung verbunden sein, wobei angezeigt wird, wie die gewünschte Funktion oder Teilfunktion erzeugt werden kann, beispielsweise die Lautstärke für das Autoradio oder die Umschaltung vom Bordcomputer auf das Autotelefon.

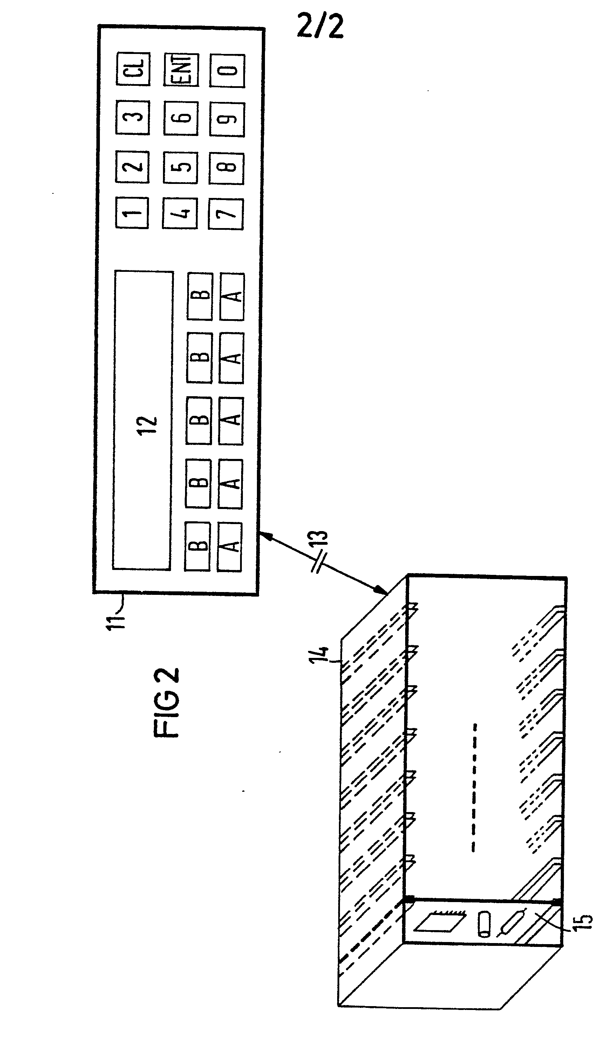

In der Fig. 2 ist ein Ausführungsbeispiel für ein erfindungsgemäßes Multifunktonsbedienteil dargestellt. Das Bedienteil 11 weist dabei auf der rechten Seite eine Zifferneingabe mittels Drucktasten mit Korrekturmöglichkeit und Enterfunktion auf. Mit den Funktionsgruppenschaltern A werden die einzelnen Geräte wie Autoradio, Bordcomputer, Autotelefon bestimmt. Bei dem Ausführungsbeispiel nach der Fig. 2 ist eine Anwählmöglichkeit für fünf verschiedene Geräte vorgesehen. Mit den Bedienelementen B erfolgt die gewünschte Beeinflussung des gewählten Gerätes, wie beispielsweise Einstellung der Lautstärke beim Autoradio bzw. Umschaltung auf einen anderen Wellenbereich.

Auf der Anzeigeeinheit 12 wird der Betriebsmode, die Information bzw. Benutzerführung vermittelt.

Das Multifunktionsbedienteil 11 kann beispielsweise als LCD-Matrixdisplay ausgebildet sein, wobei die Zifferneingabe, die Funktionsgruppenschalter und Bedienelemente als Sensortasten mit wahlfreier LCD-Beschriftung ausgeführt sind.

Über die serielle Datenschnittstelle 13 ist das Bedienteil 11 mit einer Elektronikeinheit 14 verbunden, welche beispielsweise Einschubrahmen für Flachbaugruppen 15 für die einzelnen Geräte, wie Autoradio, Autotelefon, Bordcomputer usw. aufweist.

Die Elektronikeinheit 14 kann dabei an beliebiger Stelle eines Kraftfahrzeuges untergebracht sein, wogegen das Bedienteil 11 vorzugsweise derart angeordnet ist (zum Beispiel am Armaturenbrett oder auf der Mittelkonsole), daß es durch den Kraftfahrzeuglenker bedient werden kann. Bei Ausbildung der seriellen Datenschnittstelle 13 für eine Infrarot-Datenübertragung ist das Bedienteil 11 dagegen frei beweglich.

10 Patentansprüche
2 Figuren

Patentansprüche

1. Multifunktionsbedienteil insbesondere für Kraftfahrzeuge, d a d u r c h   g e k e n n z e i c h n e t , daß das Bedienteil die folgenden Funktionsgruppen aufweist:

a) Eine Zifferneingabe
b) eine Funktionsgruppenumschaltung
c) Bedienelemente
d) eine Anzeigeeinheit
e) eine serielle Schnittstelle für eine Elektronikeinheit

2. Multifunktionsbedienteil nach Anspruch 1, d a - d u r c h   g e k e n n z e i c h n e t , daß die serielle Schnittstelle für einen elektrischen Datenbus ausgebildet ist.

3. Multifunktionsbedienteil nach Anspruch 1, d a - d u r c h   g e k e n n z e i c h n e t , daß die serielle Schnittstelle für eine Infrarot-Datenübertragung ausgebildet ist.

4. Multifunktionsbedienteil nach einem der Ansprüche 1 bis 3, d a d u r c h   g e k e n n z e i c h n e t , daß die Zifferneingabe, die Funktionsgruppenumschaltung und die Bedienung mittels Drucktasten erfolgt.

5. Multifunktionsbedienteil nach einem der Ansprüche 1 bis 3, d a d u r c h   g e k e n n z e i c h n e t , daß die Zifferneingabe, die Funktionsgruppenumschaltung und die Bedienung mittels Drehschaltern erfolgt.

6. Multifunktionsbedienteil nach einem der Ansprüche 1
bis 3, d a d u r c h   g e k e n n z e i c h n e t ,
daß die Zifferneingabe, die Funktionsgruppenumschaltung
und die Bedienung mittels Sensortasten erfolgt.

7. Multifunktionsbedienteil nach einem der Ansprüche 1
bis 3, d a d u r c h   g e k e n n z e i c h n e t ,
daß die Zifferneingabe, die Funktionsgruppenumschaltung
und die Bedienung mittels Spracherkennung erfolgt.

8. Multifunktionsbedienteil nach einem der Ansprüche 1
bis 7, d a d u r c h   g e k e n n z e i c h n e t ,
daß die Anzeigeeinheit als LCD-Display ausgebildet ist.

9. Multifunktionsbedienteil nach einem der Ansprüche 1
bis 8, d a d u r c h   g e k e n n z e i c h n e t ,
daß Zifferneingabe, Funktionsgruppenumschaltung, Bedienelemente und Anzeigeeinheit auf einem LCD-Matrixdisplay
mit überlagerten Sensortasten angeordnet sind.

10. Multifunktionsbedienteil nach einem der Ansprüche 1
bis 9, d a d u r c h   g e k e n n z e i c h n e t ,
daß es als tragbares Gerät ausgebildet ist.

FIG1

FIG 2